# EUROPEAN PATENT APPLICATION

(11) **EP 4 790 432 A2**
(43) Date of publication of application: **12.08.2026**
(21) Application number: 26157152.5
(22) Date of filing: 09.02.2026
(51) Int. Cl.: G01R 19/165, G01R 31/389

(54) **SYSTEM AND METHOD FOR ESTIMATING BATTERY CHARACTERISTICS IN INTEGRATED MOTOR DRIVE**

(30) Priority: 07.02.2025 US 202563755307 P; 02.02.2026 US 202619466783
(71) Applicant: Magna International Inc., Aurora, ON L4G 7K1 (CA)
(72) Inventor: Lewoc, Philip, AURORA, ONTARIO, L4G 7K1 (CA); Viana, Caniggia, AURORA, ONTARIO, L4G 7K1 (CA); Korta, Philip, AURORA, ONTARIO, L4G 7K1 (CA); Amezyane, Ibrahim, AURORA, ONTARIO, L4G 7K1 (CA); Iyer, Lakshmi Varaha, AURORA, ONTARIO, L4G 7K1 (CA); Kar, Narayan C., AURORA, ONTARIO, L4G 7K1 (CA)
(74) Representative: Witte, Weller & Partner Patentanwälte mbB

(57) **Abstract**

A method for determining a battery current in an integrated motor drive (IMD) system having a plurality of integrated power modules includes: generating, by a power electronics assembly of an integrated power module, alternating current (AC) power on a set of load terminals using DC power from the one or more battery cells connected to a DC port of the integrated power module; determining a total DC current on the DC port of the integrated power module; measuring a battery voltage of the one or more battery cells of the integrated power module; determining, based on the battery voltage, a capacitor current through a DC link capacitor connected in parallel with the one or more battery cells of the integrated power module; and determining, based on the total DC current and the capacitor current, the battery current in the one or more battery cells of the integrated power module.

## Description

### FIELD

The present disclosure relates generally to systems and methods for operating an integrated motor drive having a plurality of integrated power modules, each including a battery and a power electronics assembly physically and electrically coupled to the battery. More specifically, the present disclosure relates to estimating battery characteristics in an integrated motor drive.

### BACKGROUND

An integrated motor drive (IMD) system is a multi-level modular converter-based system. Relative to conventional electric vehicle powertrain systems, the IMD architecture breaks the battery pack of the vehicle down into multiple modules per individual phase.

A vehicle may employ such an IMD system to control direct current (DC) power for charging batteries and to produce and control alternating current (AC) and/or direct current (DC) power for supply to various different types of loads.

### SUMMARY

The present disclosure provides a method for determining a battery current (*I_{batt}*) in an integrated motor drive (IMD) system having a plurality of integrated power modules. Each of the integrated power modules includes one or more battery cells and a power electronics assembly physically and electrically coupled to the one or more battery cells. The method comprises: generating, by the power electronics assembly of an integrated power module of the plurality of integrated power modules, alternating current (AC) power on a set of load terminals using direct current (DC) power from the one or more battery cells connected to a DC port of the integrated power module; determining a total DC current (*I_{dc}*) on the DC port of the integrated power module; measuring a battery voltage (*V_{batt}*) of the one or more battery cells of the integrated power module; determining, based on the battery voltage (*V_{batt}*), a capacitor current (*I_{cap}*) through a DC link capacitor connected in parallel with the one or more battery cells of the integrated power module; and determining, based on the total DC current (*I_{dc}*) and the capacitor current (*I_{cap}*), the battery current (*I_{batt}*) in the one or more battery cells of the integrated power module.

The present disclosure also provides a method for determining an impedance spectrum of a battery in an integrated motor drive (IMD) system having a plurality of integrated power modules. Each of the integrated power modules includes one or more battery cells and a power electronics assembly that is physically and electrically coupled to the one or more battery cells and configured to generate an alternating current (AC) power on a set of load terminals using DC power from the one or more battery cells of the integrated power module and for driving a motor having a winding connected to the set of load terminals. The method comprises: commanding a plurality of switches in the power electronics assembly of an integrated power module of the plurality of integrated power modules to draw a sinusoidal battery current (*I_{batt}*) from the one or more battery cells of the integrated power module and having a value with a small amplitude that is substantially smaller than an amplitude of the battery current (*I_{Batt}*) when operating integrated power module for driving the motor; measuring a battery voltage (*V_{batt}*) of the one or more battery cells of the integrated power module; adjusting the commanding of the plurality of switches in the power electronics assembly to adjust a frequency of the sinusoidal battery current (*I_{batt}*) to step between a plurality of different frequency values; recording, at each of the plurality of different frequency values, waveforms of the sinusoidal battery current (*I_{batt}*) and the battery voltage (*V_{batt}*) of the one or more battery cells of the integrated power module; and determining, based on the waveforms of the sinusoidal battery current (*I_{batt}*) and the battery voltage (*V_{batt}*), real and imaginary impedance values of the one or more battery cells of the integrated power module at each of the plurality of different frequency values, thereby providing the impedance spectrum of the one or more battery cells of the integrated power module.

The present disclosure also provides an integrated motor drive (IMD) system. The IMD system comprises: a plurality of integrated power modules. Each of the integrated power modules includes one or more battery cells and a power electronics assembly physically and electrically coupled to the one or more battery cells and configured to generate AC power on a set of load terminals using DC power from the one or more battery cells connected to a DC port of the integrated power module. The plurality of integrated power modules are arranged to supply the AC power to a motor via an output terminal. The IMD system further comprises: a phase voltage sensor configured to measure a phase voltage of the output terminal; and a controller. The controller is configured to: receive a signal from the phase voltage sensor representing the phase voltage of the output terminal; determine a step change in the phase voltage of the output terminal; determine, based on the step change in the phase voltage of the output terminal, a DC-side battery current of the one or more battery cells of at least one of the plurality of integrated power modules; and adjust an operating characteristic of the power electronics assembly of the at least one of the plurality of integrated power modules based on the DC-side battery current of the one or more battery cells of at least one of the plurality of integrated power modules.

These and other aspects of the present disclosure are disclosed in the following detailed description of the embodiments, the appended claims, and the accompanying figures

### BRIEF DESCRIPTION OF THE DRAWINGS

Further details, features and advantages of designs of the invention result from the following description of embodiment examples in reference to the associated drawings.
FIG. 1 shows a schematic block diagram of an electrical system in an electrified vehicle (EV), and in accordance with an aspect of the present disclosure;
FIG. 2 shows a schematic diagram of an integrated motor drive (IMD) system, according to the present disclosure;
FIG. 3 shows a schematic diagram of the A-phase driver of the IMD system of FIG. 1, and where the motor is represented by an equivalent inductance, according to the present disclosure;
FIG. 4 shows a graph illustrating switching signals and currents in the A-phase driver of the IMD system and over a common time scale. , according to the present disclosure;
FIGs. 5A-5B show graphs of actual currents and calculated currents, respectively, in a phase driver of the IMD system, according to the present disclosure;
FIG. 6 shows a graph illustrating residual values between true battery current and a back-calculated battery current from a simulation result, according to the present disclosure;
FIG. 7 shows a schematic diagram illustrating a circuit used for back-calculation of DC side current from switching signal and measured phase current, according to the present disclosure;
FIGs. 8A-8B show graphs of total DC side current and battery currents over time and their Fourier transforms, respectively, according to the present disclosure;
FIG. 9 shows a schematic diagram representing an abstraction of an IMD system;
FIG. 10 shows a graph illustrating A-phase voltage in the IMD system; and
FIG. 11 shows a diagram illustrating a function mapping from function f to g, to h, and vice-versa.
FIG. 12 shows a flow chart of steps in a method for determining a battery current in an integrated motor drive system, in accordance with some embodiments of the present disclosure.
FIG. 13 shows a flow chart of steps in a method for determining an impedance spectrum of a battery in an integrated motor drive (IMD) system, in accordance with some embodiments of the present disclosure.
FIG. 14 shows a graph indicating DC-DC converter output voltage from each of a switched model and an average model.
FIG. 15 shows a schematic diagram representing an average converter model of a full bridge inverter.
FIG. 16 shows a schematic diagram of a power converter with an H-bridge configuration.
FIG. 17 shows a graph illustrating duty cycles of switches in the power converter of FIG. 16 with and without added deadtime.
FIG. 18 shows a graph illustrating phase current being nearly constant over the duration of a switching period.
FIG. 19 shows a graph illustrating a constant current estimation over the duration of a switching period.
FIGs. 20A-20D show a power converter with an inductor and at various switching conditions.
FIG. 21 shows a graph illustrating battery current in the power converter of FIGs. 20A-20D and over the course of a single switching period.
FIG. 22 shows a graph illustrating battery current in the power converter of FIGs. 20A-20D and over the course of a fundamental period.
FIG. 23 shows graphs illustrating deadtime in the power converter of FIGs. 20A-20D and in three different cases.

### DETAILED DESCRIPTION

Referring to the drawings, the present invention will be described in detail in view of following embodiments.

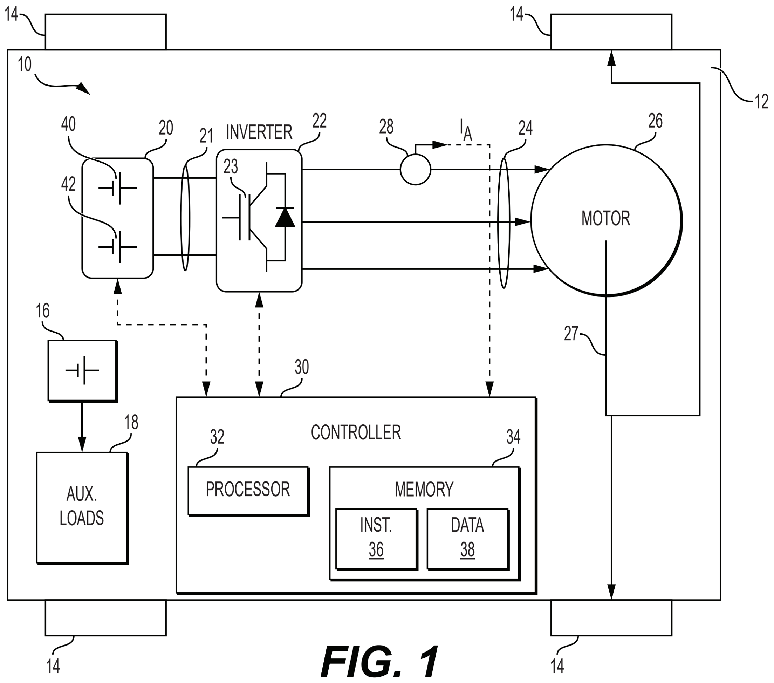

FIG. 1 shows a block diagram of an electrical system 10 for operating an electrified vehicle (EV). The EV may be configured as a battery electric vehicle (BEV), a plug-in hybrid electric vehicle (PHEV) or another type of hybrid electric vehicle that uses battery electric in combination with another source of energy for propulsion. The electrical system 10 is provided in a vehicle 12 having four wheels 14. The electrical system 10 includes a first battery 16 configured to supply power to one or more auxiliary loads 18. The axillary loads may include low-power functional elements in the vehicle 12, such as heating ventilation and air conditioning (HVAC) motors, lighting loads, such as headlights and tail lights, power steering and power brake motors, seat heaters, electrical control units (ECUs), seat actuators, window actuators, etc. The first battery 16 may be configured as a low-voltage battery, which may have an operating voltage of, for example, 12-Volts, 24-Volts, 36-Volts, 42-Volts, or 48-Volts.

The electrical system 10 also includes a traction power source 20 that is configured to supply electrical power to an inverter 22 via a direct current (DC) bus 21 for driving one or more traction motors 26 for propelling the vehicle 12. The traction power source 20 includes a second electrical energy storage device 40, which may be configured as a high-capacity main battery. Additionally or alternatively, the second electrical energy storage device 40 may include one or more capacitors.

The traction power source 20 also includes a third electrical energy storage device 42, which may be configured as a high-performance boost battery that is capable of delivering relatively high output power for a short duration of time. In some embodiments, the third electrical energy storage device 42 includes a battery, which may have a different chemistry than the first battery 16 and/or the second electrical energy storage device 40. Alternatively or additionally, the third electrical energy storage device 42 may include one or more capacitors, which may include super capacitors. The second electrical energy storage device 40 and/or the third electrical energy storage device 42 may have a relatively higher voltage, such as 400 Volts Direct Current (VDC) or 800 VDC.

The inverter 22 may include at least three pairs of solid-state switches 23, such as field effect transistors (FETs) configured to switch current from the DC bus 21 and to generate an AC power upon a set of motor leads 24. The motor leads 24 transmit electrical power between the inverter 22 and a traction motor 26. The traction motor 26 may be a permanent magnet synchronous motor (PMSM). The traction motor 26 may be used as a motor, a generator, or as a motor/generator that functions as both a motor and a generator. The traction motor 26 may include an output shaft 27 that is coupled, either directly or via a transmission or gearbox (not shown in the FIGs), to one or more of the wheels 14 of the vehicle 12 for driving the vehicle 12.

A current sensor 28 is arranged to measure current in one or more of the motor leads 24. In some embodiments, and as shown on FIG. 1, the current sensor 28 measures an A-phase current iₐ, on a corresponding one of the motor leads 24. However, the electrical system 10 may measure current on two or more of the motor leads 24. The electrical system 10 may include other sensors, such as voltage sensors configured to measure voltages upon or between the motor leads 24. If voltage sensors are available, they can be used as inputs for the provided approach.

The electrical system 10 of FIG. 1 also includes a controller 30, which may also be called an electronic control unit (ECU), in communication with the current sensor 28 to measure the currents in the motor leads 24. The controller 30 may also be in functional communication with the inverter 22 to control operation of the inverter 22 and/or to monitor parameters measured by sensors associated with the inverter 22. The controller 30 includes a processor 32 coupled to a storage memory 34. The storage memory 34 stores instructions, such as program code for execution by the processor 32, in an instruction storage 36. The storage memory 34 also includes data storage 38 for holding data to be used by the processor 32. The data storage 38 may record, for example, values of the parameters measured by the current sensor 28 and/or the outcome of functions calculated by the processor 32.

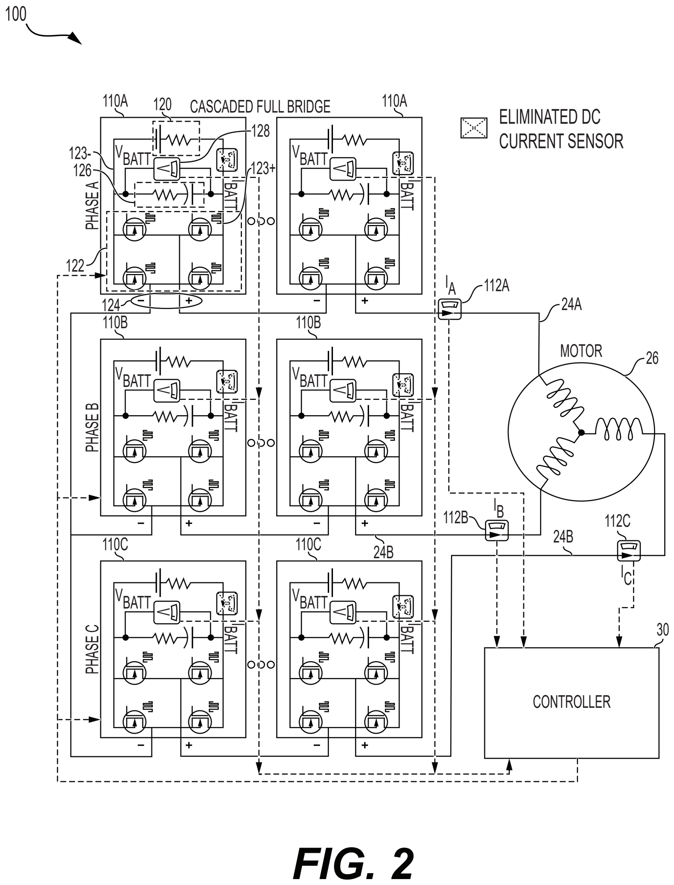

FIG. 2 shows a schematic diagram of an integrated motor drive (IMD) system 100, according to the present disclosure.

The IMD system 100 includes a plurality of integrated power modules 110a, 110b, 110c, including a plurality of a-phase integrated power modules 110a connected in series to supply current to the traction motor 26 via an a-phase motor lead 24a of the motor leads 24. An a-phase current sensor 112a is arranged to measure the a-phase current *Iₐ* in the a-phase motor lead 24a. The IMD system 100 also includes a plurality of b-phase integrated power modules 110b connected in series to supply current to the traction motor 26 via a b-phase motor lead 24b of the of the motor leads 24. A b-phase current sensor 112b is arranged to measure the b-phase current *I_{b}* in the b-phase motor lead 24b. The IMD system 100 also includes a plurality of c-phase integrated power modules 110c connected in series to supply current to the traction motor 26 via a c-phase motor lead 24c of the of the motor leads 24. A c-phase current sensor 112c is arranged to measure the c-phase current *I_{c}* in the c-phase motor lead 24c. The controller 30 may be configured to receive signals from each of the phase current sensors 112a, 112b, 112c representing the respective phase currents *Iₐ, I_{b}, I_{c}.*

Each of the integrated power modules 110a, 110b, 110c may have a similar or identical construction. For ease and simplicity, internal features and construction of only one of the integrated power modules 110a, 110b, 110c is described herein.

Each of the integrated power modules 110a, 110b, 110c includes one or more battery cells 120, which may be represented schematically as a battery cell in series with a resistance. Each of the integrated power modules 110a, 110b, 110c also includes a power electronics assembly 122 that is physically and electrically coupled to the one or more battery cells 120. The power electronics assembly 122 may include four field-effect transistors (FETs) arranged in an h-bridge configuration. The power electronics assembly 122 defines a DC port 123+, 123-having a DC positive terminal 123+ and a DC negative terminal 123-. The power electronics assembly 122 is electrically connected to the one or more battery cells 120 and is configured to generate alternating current (AC) power on a set of load terminals 124 using DC power from the one or more battery cells 120 connected the DC port 123+, 123- thereof. The controller 30 may be configured to command operation of the power electronics assembly 122, for example by sending pulse-width modulation (PWM) signals to control each of the FETs to selectively conduct current.

The load terminals 124 of the a-phase integrated power modules 110a are each connected in series to supply the current to the traction motor 26 via the a-phase motor lead 24a of the of the motor leads 24. The load terminals 124 of the b-phase integrated power modules 110b and the c-phase integrated power modules 110c, may be similarly connected in series and with a corresponding one of the b-phase motor lead 24b and the c-phase motor lead 24c.

Each of the integrated power modules 110a, 110b, 110c also includes a DC link capacitor 126 that is connected in parallel with the one or more battery cells 120. The DC link capacitor 126 may be represented schematically by a resistor in series with a capacitor, which may also be called an RC series branch. This resistor-capacitor combination may represent resistive and capacitive effects of a single capacitor device. Alternatively, the DC link capacitor 126 may include separate resistor and capacitor devices.

Each of the integrated power modules 110a, 110b, 110c also includes a battery voltage sensor 128 that is configured to measure a battery voltage *V_{batt}* of the one or more battery cells 120. The controller 30 may be configured to receive signals from each of the battery voltage sensor 128 representing the respective battery voltages *V_{batt}.*

The Integrated Motor Drive (IMD) System - The IMD system is a multi-level modular converter-based system. Relative to conventional electric vehicle powertrain systems, the IMD architecture breaks the battery pack of the vehicle down into multiple modules per individual phase. These modules are then put in a pseudo series configuration with one another, where the output of a full bridge inverter placed on each individual module is tied to the next module in phase, as shown in FIG. 2.

In the system presented, each of the series modules will contribute to the overall phase voltage as per their modulation index, while the phase current through all of the modules will be the same given they are in series on the AC side. Examining the architecture, it becomes apparent that a large number of sensors are required in order to safely operate. For each module a DC voltage and current sensor is required in order to ensure operational limits of the battery are not violated, and to track the state of charge during runtime. This means that if "n" number of modules are deployed in the system, "n" number of voltage and current sensors will be required as well. Thus, a solution has been developed in order to eliminate the need of the DC side current sensor in the IMD application, as well as any switched converter application with an AC side current sensor and DC side voltage sensor.

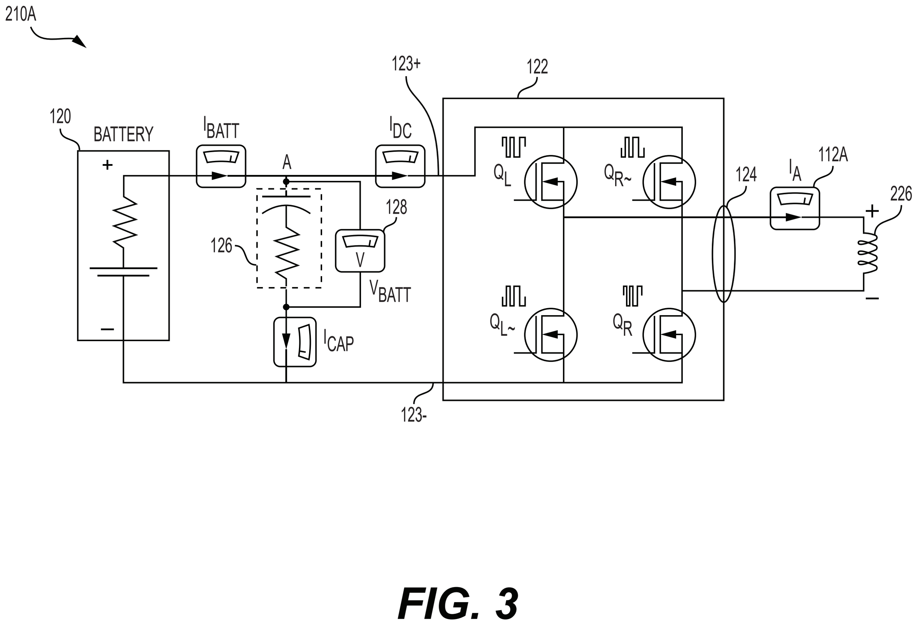

Current Sensor Elimination - Current sensor elimination can be performed through a variety of potential avenues- most commonly it has been found to be achieved by representing the system of interest in a state space format, then applying an observer to estimate the current. The general premise observer-based systems work upon is by having the state space model predict a quantity in the system that can be directly measured with a reliable sensor. The error between the state space models prediction and the true measured value from the sensor output can then be used as a gain to adjust the internal (hidden) state of the state space model, until the measured value and calculated value converge. This should also correspond to the point where the hidden state has converged to the true value of whatever we desire to observe in the system. In the context of the full bridge system of the IMD as seen in FIG. 3, this could mean using a state space model of the battery to predict the battery voltage based off the battery current Ibatt. Vbatt is then used as feedback to the observer, and the error between the battery model's prediction of the terminal voltage and measured voltage is used to estimate the battery current of interest. The measured voltage in this case can come from either the battery monitoring IC of the battery management system or a dedicated voltage sensing module placed at node A.

The current sensor elimination technique proposed instead will leverage the switching pattern of the individual switches in the full bridge to back calculate the total DC current *I_{dc}.* Then, since the battery module voltage sensor is in parallel with the DC link capacitor, a discretized transfer function of the capacitor will be used to calculate the capacitor branch current *I_{cap}.* Afterwards, the battery current will simply be the sum of the currents at node A, as shown in FIG. 3.

FIG. 3 shows a schematic diagram of the A-phase driver 210a of the IMD system 100 of FIG. 2, and where the traction motor 26 is represented by an equivalent inductance 226, according to the present disclosure. The A-phase driver 210a includes internal details of the power electronics assembly 122, showing each of the four FETs Q_{L}, Q_{R}, Q_{L~}, and Q_{R~}. The A-phase driver 210a also includes additional sensors for measuring the battery current *I_{batt}* in the one or more battery cells 120, the capacitor current *I_{cap}* in the DC link capacitor 126, and the total DC current *I_{dc}* supplied to the power electronics assembly 122 via the DC port 123+, 123-. The total DC current *I_{dc}* may, therefore, represent a difference between the battery current *I_{batt}* and the capacitor current *I_{cap}.* Alternatively, and if the capacitor current *I_{cap}* is defined to be positive for current toward node A, the total DC current *I_{dc}* may represent a sum of the battery current *I_{batt}* and the capacitor current *I_{cap}.*

The first step in the process of eliminating the DC current sensor is to calculate the total DC current *I_{dc}.* Considering a unipolar PWM in reference to FIG. 2, Table. 1 shows the possible switching scenarios, wherein a 1 represents the corresponding FET being in a conductive state, and a 0 represents the corresponding FET being in a non-conductive state.

**Table.1 - Possible Switching Combinations of Full Bridge Switches**

| QL | QR | QL~ | QR~ | QL + QR | QL + QR -1 | Iₐ * (QL + QR - 1) |
|---|---|---|---|---|---|---|
| 1 | 0 | 0 | 1 | 1 | 0 | 0 |
| 1 | 1 | 0 | 0 | 2 | 1 | Iₐ |
| 0 | 1 | 1 | 0 | 1 | 0 | 0 |
| 0 | 0 | 1 | 1 | 0 | -1 | -Iₐ |

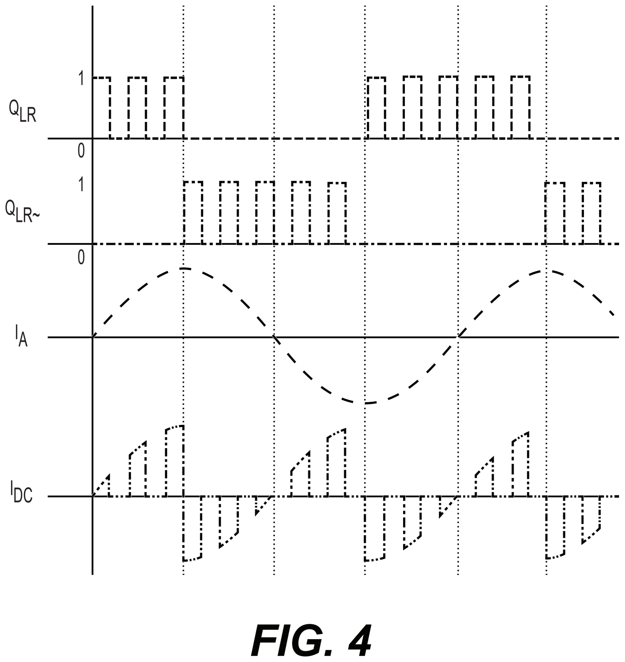

When both QL and QR are high, the battery applies a positive potential across the load, causing for a positive DC side current, while when QL~ and QR~ are high the battery applies a negative potential to the load, causing a negative DC current. Thus, since the switching pattern of QL and QR is known, subtracting one from the summation of QL and QR's switching state (to account for the flip in polarity), then multiplying it by the measured phase current will yield the true value of the DC side current *I_{dc}.* The visual representation of this back calculation is shown in FIG. 4.

FIG. 4 shows a graph illustrating switching signals and currents in the A-phase driver of the IMD system and over a common time scale, according to the present disclosure. FIG. 4 graphically represents a back calculation of the DC side current *I_{dc}* from switching signals Q_{LR}, Q_{LR~} and measured A-phase current *Iₐ.*

With the total DC current *I_{dc}* calculated, the next step is to calculate the current through the RC series branch by leveraging the voltage sensor placed in parallel with the DC link capacitor. The transfer function of the series RC branch can be formed as equation (1), below, where the capacitance is *C_{f}* and the resistance in series with the capacitor is *R_{f}.* $\frac{{I}_{cap} \left(s\right)}{{V}_{cap} \left(s\right)} = \frac{{C}_{f} ⋅ s}{{C}_{f} {R}_{f} s + 1}$

For real time calculation of capacitor branch current, this can then be discretized using the Z-transform. In this case, Tustin's transform was used, and the transfer function was discretized as shown in equations (2) - (3), below, where *Tₛ* represents the desired sampling time of the system. $Let s = \frac{2}{{T}_{s}} \left(\frac{z - 1}{z + 1}\right)$ $\frac{{I}_{cap} \left(z\right)}{{V}_{cap} \left(z\right)} = \frac{2 {C}_{f} z - 2 {C}_{f}}{z \left(2{C}_{f}{R}_{f}+{T}_{s}\right) + \left({T}_{s}-2{C}_{f}{R}_{f}\right)}$

This can then be finally represented as a general difference equation (4): ${I}_{cap} \left[k\right] = \frac{{V}_{cap} \left[k\right] ⋅ 2 {C}_{f} - {V}_{cap} \left[k-1\right] ⋅ 2 {C}_{f} - I \left[k-1\right] ⋅ \left({T}_{s}-2{C}_{f}{R}_{f}\right)}{2 {C}_{f} {R}_{f} + {T}_{s}}$

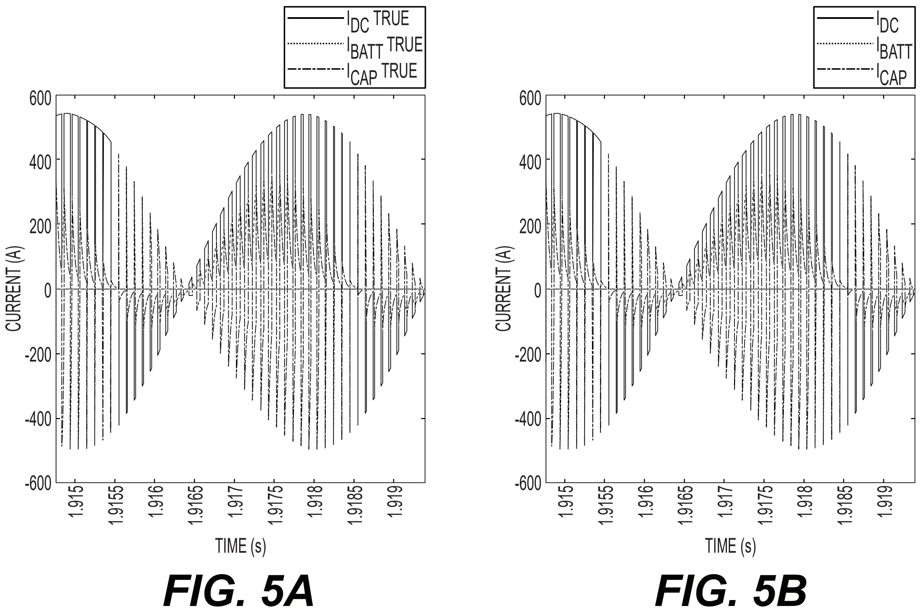

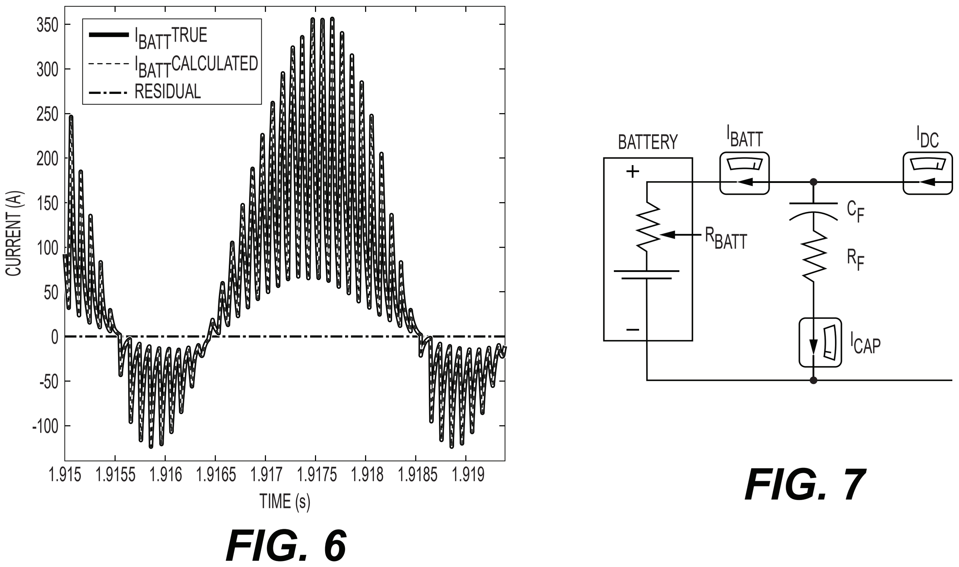

Thus, with the total DC current *I_{dc}* and capacitor branch current *I_{cap}* calculated, the DC battery current *I_{batt},* can be found as the sum of these currents, eliminating the need for the battery current sensor. To validate the described method a simulation of the IMD system powering an electric motor with a given torque and speed command was built in MATLAB Simulink. During the simulation *I_{dc}*, *I_{cap}* and *I_{batt}* represent actual currents in the IMD system, giving the resultant waveforms over a short time period seen in FIG. 5A. During the simulation the above method was used to also calculate all three currents of interest. The actual currents and calculated currents exhibited a nearly perfect match to one another, with the result seen in FIG. 5B. The calculated battery current and actual battery current plotted on one another and the residual between the two can also be seen in FIG. 6. This validates the success in eliminating the DC battery side current sensor.

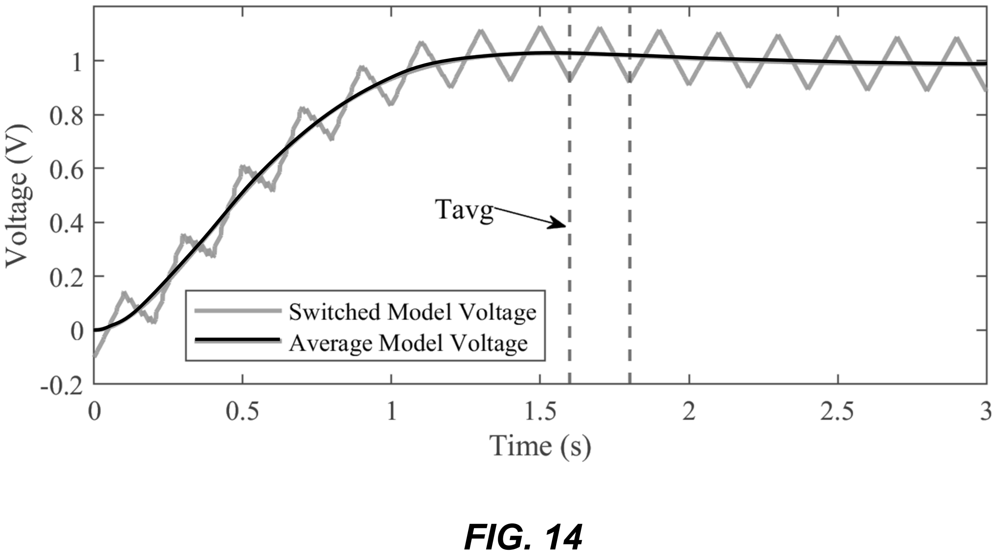

Another method for battery current estimation is also provided. To aid in the development of a framework for eliminating the battery current sensor, the average converter model of the full bridge can be used. Unlike the switched converter model, which calculates the voltage at every instant based on the switching of MOSFETs and other semiconductor devices, the average model computes average quantities over a small time period, *T_{avg}.* The period *T_{avg}* for averaging is sufficiently small such that the fundamental components of the systems are much larger relative to the averaging period. Hence, the model can accurately capture low-frequency dynamics but ignores any high-frequency phenomena. The assumption here is that the high frequency harmonics, generally caused by switching, are much smaller than the amplitude of the average signal, and hence can be ignored while still delivering an accurate general behaviour of the system. FIG. 14 illustrates the voltage tracking of a switched model and average converter model for a DC-DC converter as its output voltage increases. The average model ignores the triangular ripple as a result of switching and instead produces the effectively low-passed signal indicated.

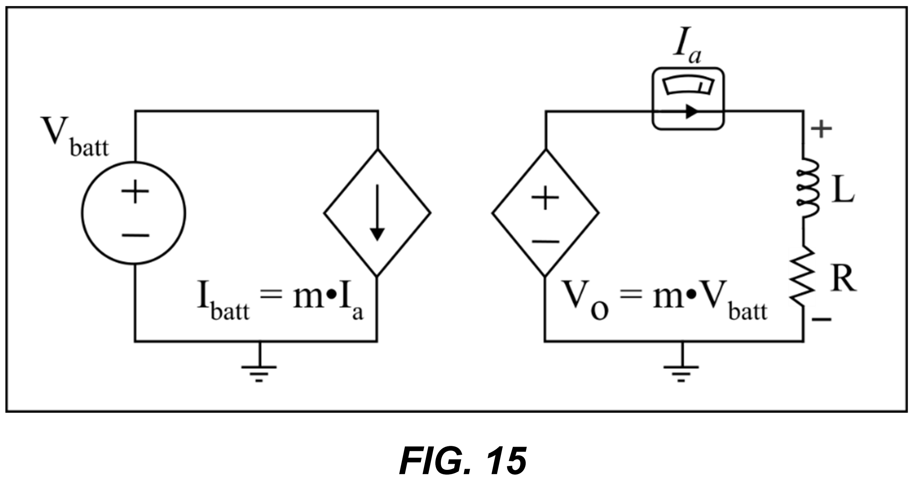

The output voltage, *Vₒᵤₜ*, of the full bridge converter is dependent on the modulating wave, m which will determine when gating signals for the converter are on or off, as well as the battery voltage, *V_{batt}.* The output voltage can then be modelled with a dependent voltage source where the output voltage is given by equation (5), below. The phase current output, *Iₐ*, will be reflected back to the battery current dependent on the modulation - current flow to or from the battery is dependent on the on and off time of the switches in the converter (phase current can still flow during zero states of the converter but battery current cannot). Hence, the expression for battery is given by equation (6), and the battery current can be seen as a dependent current source. The full average converter model is shown in FIG. 15. ${V}_{o} = m ⋅ {V}_{batt}$ ${I}_{batt} = \frac{{m}^{2} {V}_{batt}}{R + sL}$

From the model presented above the following observation can be easily made - the battery current is nothing more than the product of the modulating wave, which is provided by the control loop, and the measured phase current, as described in equation (7): ${I}_{batt} = m ⋅ {I}_{a , meas}$

Again referencing FIG. 15, this is a convenient solution. Phase current sensors are already present in the system, meaning the existing hardware can be leveraged to calculate the battery current of each module, so as long as the modulating signal of each full bridge is known. Each modulating signal is in fact readily available from the motor controller, and hence a framework for calculating the battery current from the phase current sensor and modulation is possible.

### Deadtime considerations in the average converter model

Earlier it was mentioned that the modulating signal controls the on time and off time of a given switch in the converter, which changes the resultant output voltage. This can be restated to say that the modulating signal controls the duty cycle *D* of a switch, as described by equation (8), which is the ratio of switch on time to switch off time in a given switching period, as described by equation (9). $D = \frac{m + 1}{2}$ $D = \frac{{T}_{on}}{{T}_{sw}}$

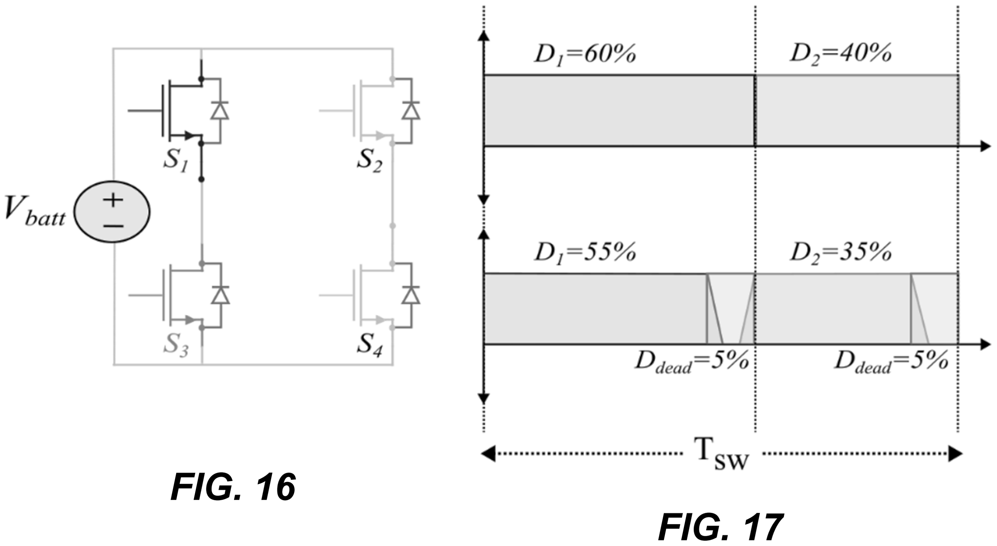

In an ideal scenario, two switches in the same leg of the converter have duty cycles related by equation (10), referencing FIGs. 16-17. ${D}_{1} + {D}_{2} = 1$

However, in practice, this is not feasible. The switches in the converter require a buffer period known as deadtime to account for the fact that the switches have an associated rise and fall time as per the bottom plot of FIG. 17. If the switches were operated without deadtime for a brief moment the left leg of the full bridge would be shorted to the battery - allowing thousands of amps to momentarily flow and potentially destroying the converter. During deadtime, neither of the switches in a leg is conducting, rather, in the case of an inductive load current flows back to the battery through the reverse body diodes of the converter, highlighted in blue above. The effective duty of the switches with deadtime may be described by equations (11) and (12), with the duty of deadtime defined as set forth in equation (13). ${D}_{1} = \frac{m + 1}{2} - {D}_{dead}$ ${D}_{2} = 1 - \frac{m + 1}{2} - {D}_{dead}$ ${D}_{dead} = \frac{{T}_{dead}}{2 {T}_{sw}}$

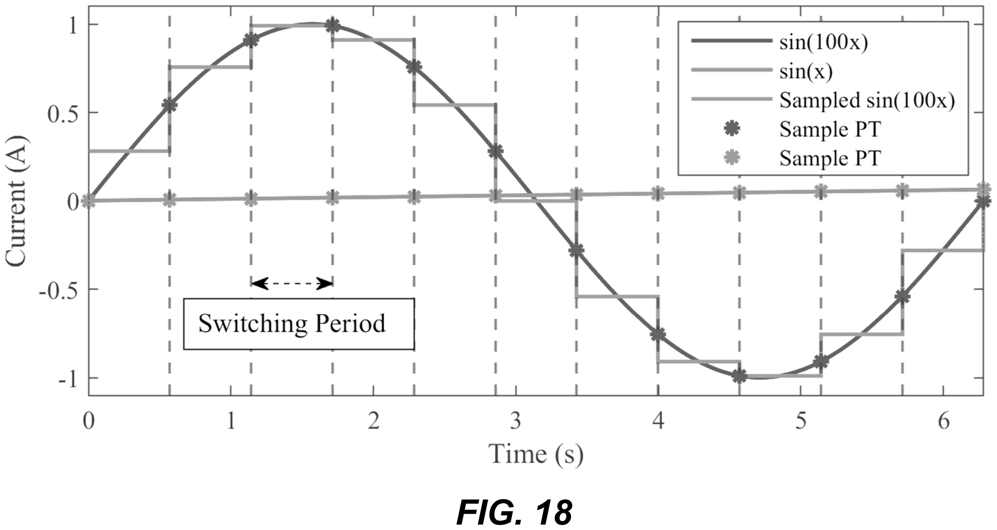

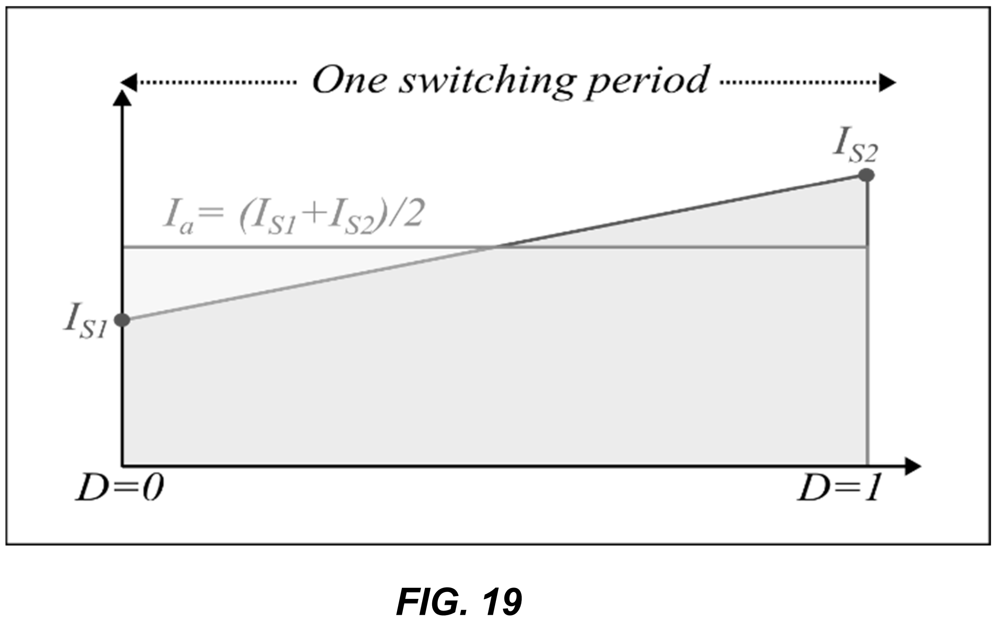

A key point to note is that the switching period is generally much smaller than the period of the phase current, as shown in FIG. 18. The phase current is sampled once at the beginning of each switching period, and two adjacent samples are averaged to produce *Iₐ* as in FIG. 19 over the respective switching period. For low frequency phase outputs, as in the sin(x) plot of FIG. 18, this is a good assumption, where it already appears nearly constant without any averaging applied. For higher-frequency sinusoids, such as the sin(100x) plot of FIG. 18, some degree of aliasing will occur, but the effect on the calculation of the battery current should be minimal. In any case, the total phase current travelling through the converter over any switching period is assumed to be constant.

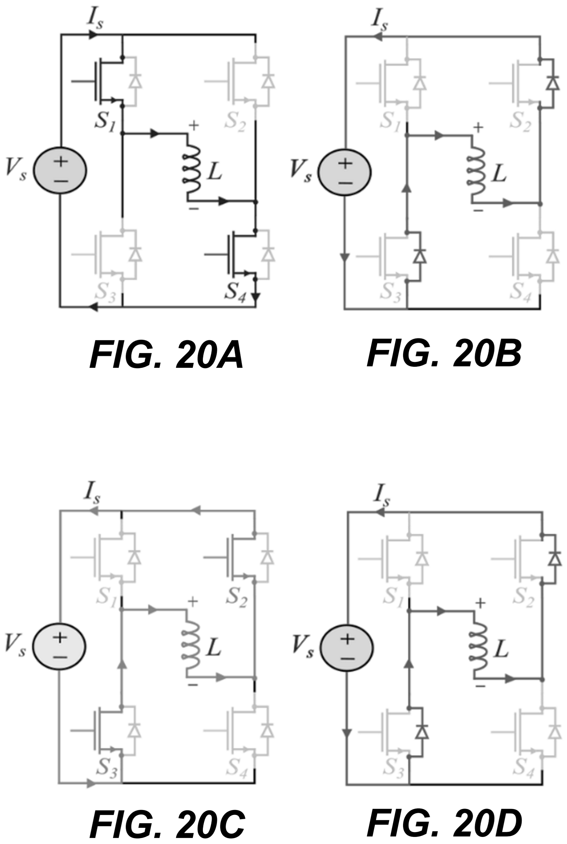

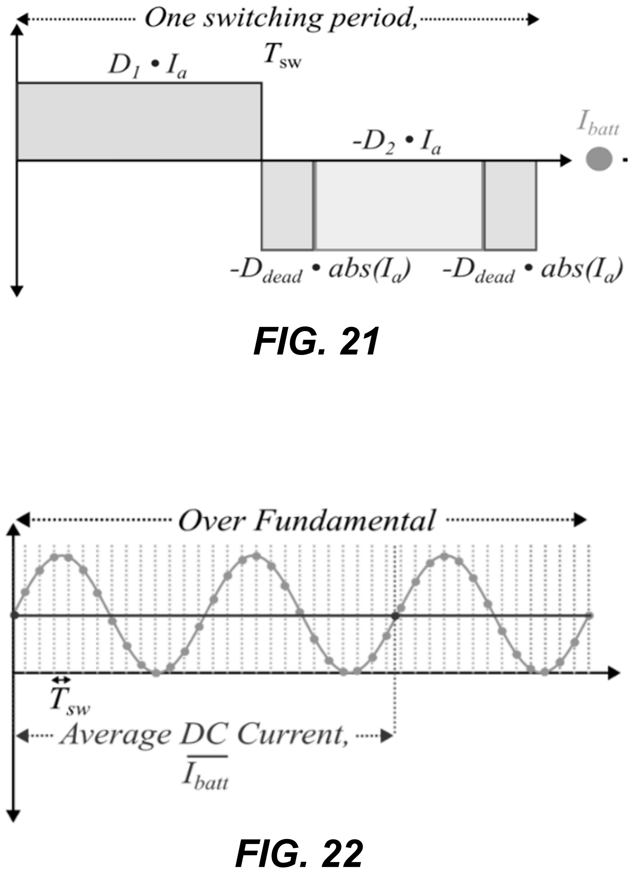

Returning to the average converter model, the problem can be slightly reframed to integrate deadtime. Instead of directly using the modulating signal, m, and measured phase current, *Iₐ*, the duties of the diagonal pairs of switches (*S*₁,*S*₄) and (*S*₂,*S*₃) can be used to determine the average battery current. Referencing FIG. 20A, during *D*₁, the battery current flows with the same polarity as the phase current for the duration of *D*₁. A period of deadtime, shown in FIG. 20B, follows in which the current maintains the same polarity across the inductance, and is thus negative relative to the battery. The next diagonal pair of switches then turn on, as shown on FIG 20C, in which again the current takes a negative polarity relative to the battery, followed by the concluding deadtime, as shown on FIG. 20D, with a negative polarity as well. Thus, knowing the phase current is constant over a switching period, multiplying the respective duties for each converter state (*D*₁, *D_{dead}*, *D*₂, *D_{dead}*) by the phase current (with the correct polarity relative to the battery) yields their contribution towards the average battery current. This is visually shown by the graph of FIG. 21, and the sum of the rectangles will yield the average battery current *I_{batt}* for a single switching period, as described by equation (14). ${I}_{batt} = {D}_{1} ⋅ {I}_{a} - {D}_{2} ⋅ {I}_{a} - 2 {D}_{dead} ⋅ abs \left({I}_{a}\right)$

Further referencing FIGs. 20A-20D and FIGs. 21-22:
- The output of the average converter model produces the average battery current, *I_{batt}* every switching period. This is the sinusoidal waveform on FIG. 22.
- This waveform can be averaged to produce the phase-averaged battery current, *I̅_̅{̅b̅a̅t̅t̅}̅* indicated and shown by the horizontal line plot on FIG. 22. On FIG. 22, the new value for *I̅_̅{̅b̅a̅t̅t̅}̅* is output every two periods of the battery current, shown by the dark dots, and uses a recursive running average formula. This average value is what is truly responsible for producing an SOC change inside of the cell, and hence accurately matching the determined average DC current to a measured value of the current sensors is the ultimate goal.

The framework developed is straightforward - use the modulation and deadtime to determine the duty of the switches and calculate the average battery current each switching period. Average these values over every two periods of the battery current (or equivalently single period of the phase) and produce the equivalent DC current responsible for discharging the battery.

### Deadtime corner cases for averaging calculations

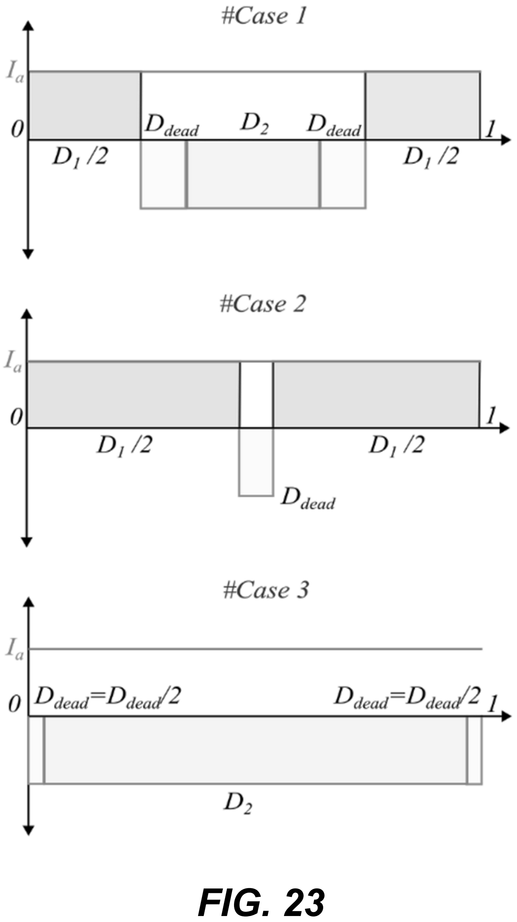

If the duty of either pair of diagonal switches is greater than 1 *- D_{dead}* this implies the other pair of diagonal switches has their gating pulse eliminated. For example, if *D_{dead}* is 0.02, and *D*₁ is 0.99, then *D*₂ = -0.01. This is impossible, and instead the switching period will allow for *D*₁ to occur at 0.98 with the correct 0.02 deadtime. Visually, this can be seen as the deadtime getting "squeezed" away as the duties of the switches become larger, exemplified in FIG. 23.

The above approaches have been tested on the IMD system. However, it should be noted that it can be applied anywhere in switched converter-based systems with an AC side current sensor and DC side voltage sensor. The application of this technique is not limited to unipolar PWM, and can be applied for other PWM schemes, including those with deadtime. This could include single full bridge systems or traditional three phase inverters, for a variety of applications including electric vehicle powertrains, grid tied inverters, or large-scale energy storage systems. Finally, the DC link capacitor in this example was modelled with a series resistance and capacitance, however it is not limited strictly to this abstraction. More complex capacitor models with parasitic inductances and resistances, or models that use lookup tables considering temperature variance could be integrated. This would further improve method robustness if deemed to have a considerable affect. The potential benefits expected to come out of the proposed invention is a decrease in hardware costs given the elimination of the DC current sensor. Additionally, still having precise information as to the DC side current is essential for safe battery use, precise state of charge tracking and allows for the application of enhanced state of health tracking algorithms as well.

### Battery Resistance Estimation:

In full bridge systems, as presented in FIG. 3, the full bridge will convert the DC side input voltage into an AC side voltage output. The frequency of the AC side voltage output is determined by the frequency of the reference signal when generating the gating pulses for the switches. As a consequence of the switching action, the DC side current, *I_{dc}*, will contain several harmonics: The DC component of the current at 0 Hz, a large harmonic at two times the reference frequency (i.e. the second harmonic), and higher order switching harmonics. The DC side capacitor in parallel with the battery will filter out all of the switching harmonics and take a portion of the second harmonic current. The battery will also take a portion of the second harmonic current, depending on how large the impedance of the battery is relative to the series RC branch at a particular reference frequency. Thus, this implies that the total DC side current *I_{dc}* will have a larger magnitude of the second harmonic than the magnitude of the battery current second harmonic, I_{batt}.

The battery can be thought of as acting as a mostly real resistance in a switched converter-based system, and thus can be seen as a voltage source with a small resistance in parallel with the DC link capacitor as in FIG. 7. Examining FIG. 7, it is important to note that C_{f} and R_{f} are known values, while R_{batt} is presently unknown. The circuit can also be seen as a current divider between the impedance of the capacitive branch and the battery, yielding the transfer function (15): $\frac{{I}_{batt} \left(jω\right)}{{I}_{dc} \left(jω\right)} = \frac{{jωC}_{f} {R}_{f} + 1}{{jωC}_{f} {R}_{f} + {jωC}_{f} {R}_{batt} + 1}$

Considering the magnitude of the Fourier transform of the currents, the ratio of the battery current to the total DC side current at any frequency is nothing more than the magnitude of the transfer function evaluated at the given frequency. Thus, taking the magnitude from equation (15) gives equation (16), and given everything but the battery resistance is known, more clearly gives equation (17). $\frac{\left|{I}_{batt}\left(jω\right)\right|}{\left|{I}_{dc}\left(jω\right)\right|} = \frac{\sqrt{{ω}^{2} {C}_{f}^{2} {R}_{f}^{2} + 1}}{\sqrt{{ω}^{2} {C}_{f}^{2} {R}_{f}^{2} + {ω}^{2} {C}_{f}^{2} {R}_{f} {R}_{batt} + {ω}^{2} {C}_{f}^{2} {R}_{batt}^{2} + 1}} where ω = 2 πf$ $\frac{\left|{I}_{batt}\left(jω\right)\right|}{\left|{I}_{dc}\left(jω\right)\right|} = \frac{\sqrt{a + 1}}{\sqrt{{bR}_{batt}^{2} + {cR}_{batt} + \left(1+d\right)}}$

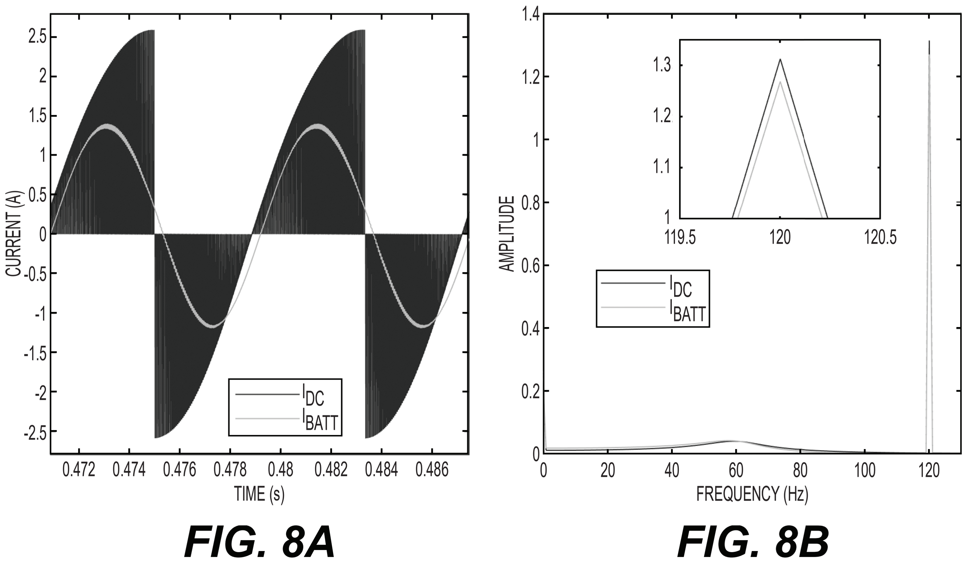

Equation (17) can be solved for the battery resistance *R_{batt}*, and thus it is possible to obtain an estimate of the real impedance of the battery in the system. To visually illustrate this, a full bridge system as in FIG. 3 was implemented in MATLAB Simulink, with a battery resistance of 1 Ohm, a capacitance of 350 microfarad, an RC branch resistance of 0.00001 Ohm and a reference frequency of 60Hz (implying second harmonic will be at 120Hz). *I_{dc}* and *I_{batt}* as well as their corresponding Fourier transforms can be seen in FIGs. 8A-8B. Using the difference in their amplitudes at the second harmonic, the battery resistance was successfully estimated to be 1.0175 Ohm, only slightly off the correct value of 1 Ohm.

This yields various potential implementations, including a new real time resistance battery estimation technique:
- In real time perform a sliding window discrete Fast Fournier Transform (FFT) on both *I_{dc}* and *I_{batt},* or periodically apply a window and compute the FFT of the current waveforms. Then use the above technique to extract an estimate of battery resistance, thus giving a real time battery resistance algorithm.
- If a real time implementation is not necessary, then the proposed technique can be applied at periodic intervals (1 week, 1 month, etc.), with longer samples of data at each interval. The longer samples of data will help in FFT resolution but are less real time friendly. The described method can then be applied to estimate battery resistance.
- If a high amount of noise is present in system measurements, which is most likely the case, a large dataset of resistance estimations can be collected and coupled with a regression model to track the change in resistance, and thus health over the lifetime of the battery module.

A potential benefit of the methods of the present disclosure includes providing a more accurate state of health (SoH) monitoring for battery modules by leveraging harmonics already found in the current waveforms. The estimated resistance of the battery modules can be regularly tracked over their lifetime and give an accurate prediction of the real impedance increase in the cells due to aging effects. This can be used to then calibrate battery management systems with a better health factor, leading to safer operating conditions and increased user reliability in the sense of better available range prediction. The proposed technique can be used anywhere in full bridge switched converter-based systems and is not limited to the IMD architecture. The described method also used a simple series RC circuit to model the impedance of the capacitor, however, once more could integrate more complex capacitor models including parasitic inductances and resistances, or lookup table based parameters.

### IMD On-Board EIS

As seen in FIG. 8A, it is theoretically possible to make a nearly sinusoidal DC side battery current as a result of having a full bridge converter directly connected to a battery module, with the motor inductance at the output. The sinusoidal DC side current will have a small harmonic ripple on it, however it may be possible to leverage it for a new online electrochemical impedance spectroscopy (EIS) technique.

The proposed technique may include the following:
- When the battery modules have been given sufficient time to rest, meaning the vehicle has been stationary for at least 15 minutes, the modules in each of the phases may be switched in such a way as to generate a small amplitude sinusoidal battery current, *I_{batt}.*
- It is important to note that the motor may be at a standstill condition and the modules in each of the phases will be using the stator windings as an inductance. Additionally, the modules in each of the phases will be discharging into and charging from one another in a periodic fashion, meaning that negligible amounts of energy are lost from the modules, implying approximately no change in state of charge.
- The frequency of *I_{batt}* will be swept from 0 Hz to the maximum allowable frequency of the system in a series of setpoints while keeping the magnitude constant, whether it be limited by the corner frequency of the DC link capacitor or the switching frequency of the full bridge inverter.
- Each frequency setpoint will be held for a short while, and I_{batt} as well as V_{batt} from the module voltage sensor will be recorded during the entire duration of the frequency setpoint.
- At each frequency setpoint an FFT of the current and voltage response of the module will be performed. The magnitude and phase difference between the waveforms will be extracted to determine the real and imaginary impedance of the battery at each frequency.
- This will generate an impedance spectrum over the frequency setpoints for each available module in IMD architecture.

An expected benefit of this technique is to provide more accurate state of health tracking on both the pack and module level for IMD use. The impedance increase in the modules can be tracked as they age and allow for diagnosis of which modules should be used, depending on how heavily they have degraded. Additionally, the ability to sweep the frequency spectrum of each of the modules will allow insight into how each module is aging, depending which part of the frequency spectrum shows noticeable change. This could allow for one to understand how to maximize the remaining lifespan of each module, as well as accurately notify when a module needs to be replaced for battery pack optimality.

### IMD Output Characterization

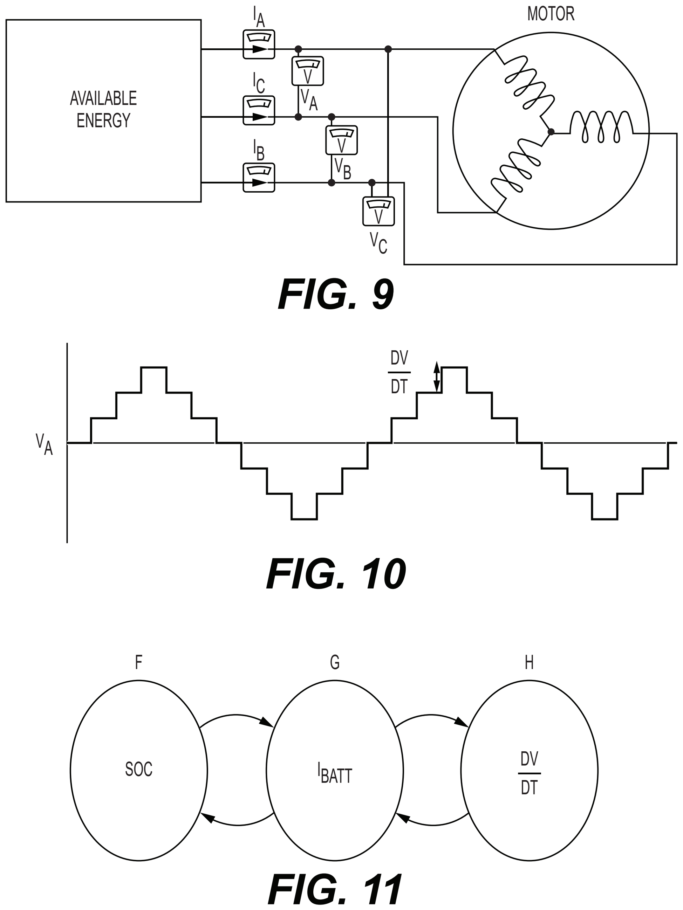

In reference to FIG. 2, the present disclosure provides a methodology to characterize the entire IMD system in regard to available energy at the motor terminals relative to the demanded energy by the motor, as per FIG. 9. This means abstracting the entire module/converter system into just how much available energy it represents and using measurements available on the motor side to gain insight as to the internal system behavior. The work would thus focus on developing functions and relations which allow for all internal system behavior to be safely controlled and understood solely on the measurements taken at the motor terminals. The resultant model proposed would thus derive the total extractable energy at the output of the IMD system as a function of the previous current and voltage history.

An example of what this could look like is creating a function which maps the entire phase A voltage, *V*ₐ, to the individual state of charges (SOC) of each of the modules in phase A. Normally this would require a DC side current sensor or voltage sensor to track the change in charge of a module, depending on what method is used for finding the DC side current. However, in the IMD system the phase voltage waveform is comprised of several different steps in voltage, each step being affected by the voltage output of a given module as seen in FIG. 10. The idea is to thus create a function which relates a present step change *dv*/*dt* in the phase voltage, as well as a history of step changes in voltage, to the DC side battery current. Then, if there is already a function relating the DC side battery current to the state of charge, one effectively has a function relating the phase voltage *Vₐ* to the SOC of the individual modules in phase A, as per FIG. 11. This is one example of how the internal system components can be abstracted, with the goal of creating an entire model which simply views the power electronic/module interface as available energy and attempts to control the motor in the most energy efficient way possible.

The present disclosure thus provides an integrated motor drive (IMD) system having a plurality of integrated power modules. Each of the integrated power modules includes one or more battery cells and a power electronics assembly physically and electrically coupled to the one or more battery cells and configured to generate AC power on a set of load terminals using DC power from the one or more battery cells connected to a DC port of the integrated power module. The plurality of integrated power modules are arranged to supply the AC power to a motor via an output terminal. The IMD system further comprises: a phase voltage sensor configured to measure a phase voltage of the output terminal; and a controller. The controller is configured to: receive a signal from the phase voltage sensor representing the phase voltage of the output terminal; determine a step change in the phase voltage of the output terminal; determine, based on the step change in the phase voltage of the output terminal, a DC-side battery current of the one or more battery cells of at least one of the plurality of integrated power modules; and adjust an operating characteristic of the power electronics assembly of the at least one of the plurality of integrated power modules based on the DC-side battery current of the one or more battery cells of at least one of the plurality of integrated power modules. For example, the controller may determine a step change in the phase voltage, as shown and described with reference to FIG. 10. The controller may then determine, based on the step change *dv*/*dt* in the phase voltage of the output terminal, a DC-side battery current *I_{batt}* of the one or more battery cells. The controller may then adjust an operating characteristic of the power electronics assembly based on the battery current *I_{batt}.* For example, the step changes change *dv*/*dt* in the phase voltage of the output terminal may be used to enhance cell balancing. The controller may adjust a charging and/or discharging current allocated to the one or more battery cells in case the DC-side battery current *I_{batt}* is indicative of an imbalance in state of charge (SoC) or state of health (SoH). Alternatively or additionally, battery cell usage may be limited or inhibited in case the battery current *I_{batt}* is indicative of a fault, such as an internal short circuit or an internal open circuit in the one or more battery cells. These are merely examples, and other operating characteristics may be adjusted based on the battery current *I_{batt}.*

The system and method of the present disclosure may provide expected benefits, including elimination of a need for any sensors internal to the available energy system, while also being able to develop a more representative holistic model of the system. For example, this means a singular model that includes all required losses and dynamics, rather than individual component models acting in conjunction with one another.

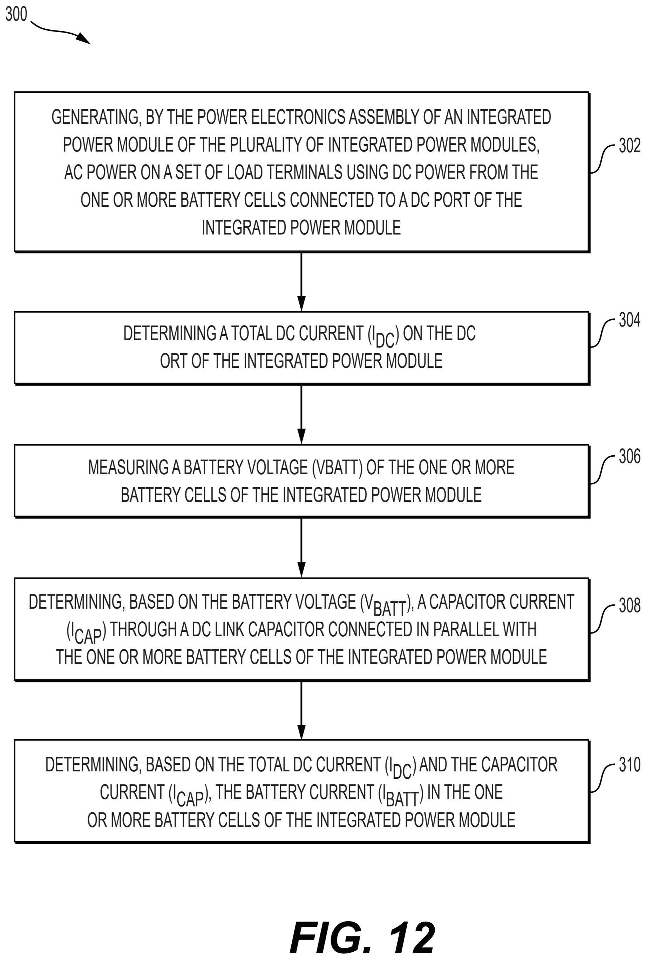

A first method 300 for determining a battery current in an integrated motor drive (IMD) system is shown in the flow chart of FIG. 12. The first method 300 can be performed by the IMD system 100, in accordance with some embodiments of the present disclosure. As can be appreciated in light of the disclosure, the order of operation within the method is not limited to the sequential execution as illustrated in FIG. 12, but may be performed in one or more varying orders as applicable and in accordance with the present disclosure.

The first method 300 includes generating, by the power electronics assembly of an integrated power module of the plurality of integrated power modules, alternating current (AC) power on a set of load terminals using DC power from the one or more battery cells connected to a DC port of the integrated power module, at step 302. For example, the controller 30 may command the four FETs Q_{L}, Q_{R}, Q_{L~}, and Q_{R~} of a power electronics assembly 122 to generate AC power on a corresponding set of load terminals 124 using DC power from one or more battery cells 120 connected to the DC port 123+, 123- of the power electronics assembly 122.

In some embodiments, step 302 includes operating the power electronics assembly of the integrated power module using a unipolar pulse-width modulation (PWM) switching technique. In some embodiments, step 302 includes operating the power electronics assembly of the integrated power module using a pulse-width modulation (PWM) switching technique with deadtime. However, a different PWM switching technique may be used.

The first method 300 also includes determining a total DC current (*I_{dc}*) on the DC port of the integrated power module, at step 304. For example, the controller 30 may calculate or otherwise estimate the total DC current (*I_{dc}*) on the DC port 123+, 123- of the power electronics assembly 122 using one or more of the techniques described herein.

The first method 300 also includes measuring a battery voltage (*V_{batt}*) of the one or more battery cells of the integrated power module, at step 306. For example, the battery voltage sensor 128 may measure the battery voltage (*V_{batt}*) of the one or more battery cells 120 and transmit information regarding the battery voltage (*V_{batt}*) to the controller 30.

The first method 300 also includes determining, based on the battery voltage (*V_{batt}*), a capacitor current (*I_{cap}*) through a DC link capacitor connected in parallel with the one or more battery cells of the integrated power module, at step 308. For example, the controller 30 may calculate or otherwise determine the capacitor current (*I_{cap}*) through the DC link capacitor 126 based on the battery voltage (*V_{batt}*) and using one or more of the techniques described herein.

In some embodiments, determining the capacitor current (*I_{cap}*) further includes calculating the capacitor current (*I_{cap}*) by modeling the DC link capacitor as a series resistor-capacitor (RC) circuit.

In some embodiments, determining the capacitor current (*I_{cap}*) further includes calculating the capacitor current (*I_{cap}*) in accordance with: ${I}_{cap} \left[k\right] = \frac{{V}_{cap} \left[k\right] ⋅ 2 {C}_{f} - {V}_{cap} \left[k-1\right] ⋅ 2 {C}_{f} - I \left[k-1\right] ⋅ \left({T}_{s}-2{C}_{f}{R}_{f}\right)}{2 {C}_{f} {R}_{f} + {T}_{s}}$ , where *C_{f}* is a capacitance of the resistor-capacitor (RC) series branch, and *R_{f}* is a resistance in series with the capacitor.

The first method 300 also includes determining, based on the total DC current (*I_{dc}*) and the capacitor current (*I_{cap}*), the battery current (*I_{batt}*) in the one or more battery cells of the integrated power module, at step 310. For example, the controller 30 may calculate or otherwise determine the battery current (*I_{batt}*) in the one or more battery cells 120 as a sum of or a difference between the total DC current (*I_{dc}*) and the capacitor current (*I_{cap}*)*.*

In some embodiments, determining the battery current (*I_{batt}*) in the one or more battery cells of the integrated power module further includes determining the battery current (*I_{batt}*) in each integrated power module of the plurality of integrated power modules.

In some embodiments, determining the total DC current (*I_{dc}*) further includes: determining a phase current (*Iₐ, I_{b}, I_{c})* of the AC power on the set of load terminals; and determining the total DC current (*I_{dc}*) based on the phase current (*Iₐ, I_{b}, I_{c}*) and based on a switching condition of the power electronics assembly. For example, the controller 30 may calculate or otherwise determine the total DC current (*I_{dc}*) based on the phase current (*Iₐ, I_{b}, I_{c}*) and based on a switching condition of the power electronics assembly 122 and as described in the present disclosure with reference to FIG. 4.

In some embodiments, the IMD system does not include any sensors for directly measuring the battery current (*I_{batt}*)*.* Instead, the battery current (*I_{batt}*) may be estimated indirectly, and using other signals, as set forth in the present disclosure.

In some embodiments, first method 300 further includes determining, based on the total DC current (*I_{DC}*) and the battery current (*I_{batt}*)*,* a battery resistance (*R_{batt}*) of the one or more battery cells of the integrated power module. In some embodiments, the first method 300 includes calculating the battery resistance (*R_{batt}*) in accordance with: $\frac{\left|{I}_{batt}\left(jω\right)\right|}{\left|{I}_{dc}\left(jω\right)\right|} = \frac{\sqrt{a + 1}}{\sqrt{{bR}_{batt}^{2} + {cR}_{batt} + \left(1+d\right)}}$, where ω is an angular speed of a modulation of the total DC current (*I_{dc}*) and is equal to 2*π* times a second harmonic frequency of the integrated power module, *j* is $\sqrt{- 1}$, and *a*, *b*, *c*, and *d* are each constants. The constants *a*, *b*, c, and *d* may be determined based on the angular speed ω and based on the capacitance *C_{f}* and the resistance *R_{f}* of the resistor-capacitor (RC) series branch. The constants *a*, *b*, *c*, and *d* may be determined as: $a = d = {ω}^{2} {C}_{f}^{2} {R}_{f}^{2} , b = {ω}^{2} {C}_{f}^{2}$ , and $c = {ω}^{2} {C}_{f}^{2} {R}_{f}$.

In some embodiments, first method 300 further includes determining, based on the battery resistance (*R_{batt}*), a state of health (SoH) of the one or more battery cells of the integrated power module.

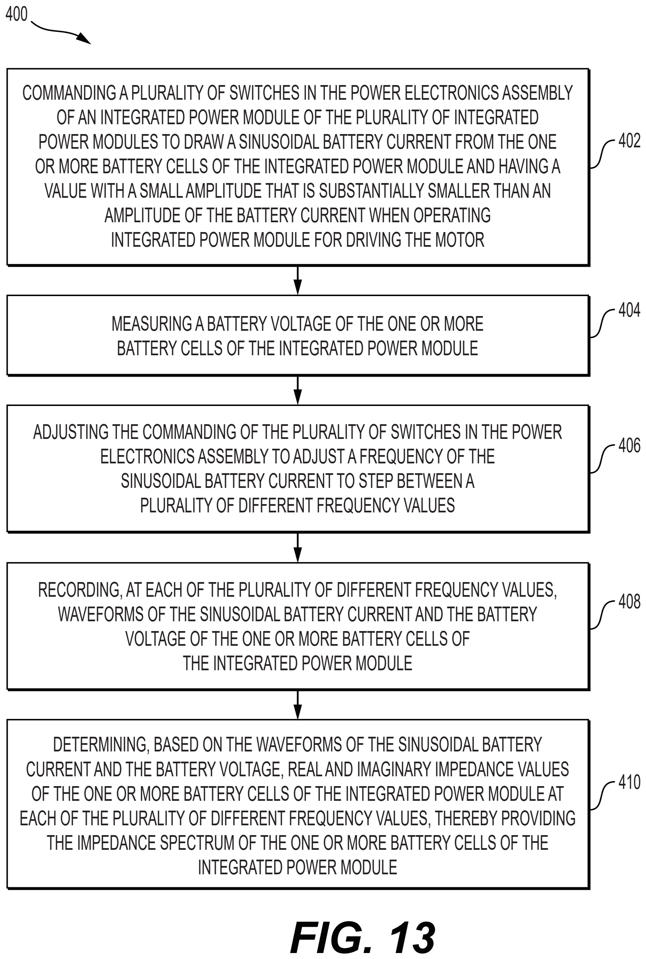

A second method 400 for determining an impedance spectrum of a battery in an integrated motor drive (IMD) system is shown in the flow chart of FIG. 13. The IMD system may include a plurality of integrated power modules, wherein each of the integrated power modules includes one or more battery cells and a power electronics assembly physically and electrically coupled to the one or more battery cells and configured to generate an alternating current (AC) power on a set of load terminals using DC power from the one or more battery cells of the integrated power module and for driving a motor having a winding connected to the set of load terminals. The second method 400 can be performed by the IMD system 100, in accordance with some embodiments of the present disclosure. As can be appreciated in light of the disclosure, the order of operation within the method is not limited to the sequential execution as illustrated in FIG. 13, but may be performed in one or more varying orders as applicable and in accordance with the present disclosure.

The second method 400 includes commanding a plurality of switches in the power electronics assembly of an integrated power module of the plurality of integrated power modules to draw a sinusoidal battery current (*I_{batt}*) from the one or more battery cells of the integrated power module and having a value with a small amplitude that is substantially smaller than an amplitude of the battery current (*I_{batt}*) when operating integrated power module for driving the motor, at step 402. For example, the controller 30 may command the four FETs Q_{L}, Q_{R}, Q_{L~}, and Q_{R~} of the power electronics assembly 122 to draw a sinusoidal battery current (*I_{batt}*) from the one or more battery cells 120 of the integrated power module 110a, 110b, 110c, and having a value with a small amplitude that is substantially smaller than an amplitude of the battery current (*I_{batt}*) when operating integrated power module for driving the traction motor 26.

The second method 400 also includes measuring a battery voltage (*V_{batt}*) of the one or more battery cells of the integrated power module at step 404. Step 404 may include measuring the battery voltage *V_{batt}* while the sinusoidal battery current (*I_{batt}*) is drawn from the one or more battery cells. For example, the battery voltage sensor 128 may measure the battery voltage (*V_{batt}*) of the one or more battery cells 120 and transmit information regarding the battery voltage (*V_{batt}*) to the controller 30.

The second method 400 also includes adjusting the commanding of the plurality of switches in the power electronics assembly to adjust a frequency of the sinusoidal battery current (*I_{batt}*) to step between a plurality of different frequency values, at step 406. For example, the controller 30 may command the four FETs Q_{L}, Q_{R}, Q_{L~}, and Q_{R~} of the power electronics assembly 122 to adjust a frequency of the sinusoidal battery current (*I_{batt}*) to step between a plurality of different frequency values.

The second method 400 also includes recording, at each of the plurality of different frequency values, waveforms of the sinusoidal battery current (*I_{batt}*) and the battery voltage (*V_{batt}*) of the one or more battery cells of the integrated power module, at step 408. For example, the controller 30 may record data representing the sinusoidal battery current (*I_{batt}*) and the battery voltage (*V_{batt}*) of the one or more battery cells 120 and at each of the plurality of different frequency values.

The second method 400 also includes determining, based on the waveforms of the sinusoidal battery current (*I_{batt}*) and the battery voltage (*V_{batt}*), real and imaginary impedance values of the one or more battery cells of the integrated power module at each of the plurality of different frequency values, thereby providing the impedance spectrum of the one or more battery cells of the integrated power module, at step 410. For example, the controller 30 may calculate or otherwise determine the real and imaginary impedance values of the one or more battery cells 120 of the integrated power module at each of the plurality of different frequency values, as set forth in the present disclosure.

In some embodiments, the second method 400 may further include determining, based on the impedance spectrum, a state of health (SoH) of the one or more battery cells of the integrated power module.

In some embodiments, determining the real and imaginary impedance values of the one or more battery cells of the integrated power module may further include calculating the real and imaginary impedance values at each of the plurality of different frequency values and using a fast Fourier transform (FFT).

In some embodiments, determining the real and imaginary impedance values of the one or more battery cells of the integrated power module may further include determining the real and imaginary impedance values of the one or more battery cells in each integrated power module of the plurality of integrated power modules.

The system, methods and/or processes described above, and steps thereof, may be realized in hardware, software or any combination of hardware and software suitable for a particular application. The hardware may include a general-purpose computer and/or dedicated computing device or specific computing device or particular aspect or component of a specific computing device. One or more steps or functions of the provided methods and/or processes may be realized in one or more microprocessors, microcontrollers, embedded microcontrollers, programmable digital signal processors or other programmable devices, along with internal and/or external memory. One or more steps or functions of the provided methods and/or processes may also, or alternatively, be embodied in an application specific integrated circuit, a programmable gate array, programmable array logic, or any other device or combination of devices that may be configured to process electronic signals. It will further be appreciated that one or more of the steps or functions of the provided methods and/or processes may be realized as a computer executable code capable of being stored on a machine-readable medium and/or executed by one or more computing hardware devices.

The computer executable code may be created using a structured programming language such as C, an object oriented programming language such as C++, or any other high-level or low-level programming language (including assembly languages, hardware description languages, and database programming languages and technologies) that may be stored, compiled or interpreted to run on one of the above devices as well as heterogeneous combinations of processors, processor architectures, combinations of different hardware and software, or any other machine capable of executing program instructions.

Thus, in one aspect, each method described above, and combinations thereof may be embodied in computer executable code that, when executing on one or more computing devices performs the steps thereof. In another aspect, the methods may be embodied in systems that perform the steps thereof and may be distributed across devices in a number of ways, or all of the functionalities may be integrated into a dedicated, standalone device or other hardware. In another aspect, the means for performing the steps associated with the processes described above may include any of the hardware and/or software described above. All such permutations and combinations are intended to fall within the scope of the present disclosure.

A processor, controller, microcontroller, electronic control unit, or other computing device or devices should be understood to mean any combination of one or more computing hardware devices, which may operate independently and/or in coordination to perform one or more computing or other data processing functions.

The foregoing description is not intended to be exhaustive or to limit the disclosure. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A method for determining a battery current (*I_{batt}*) in an integrated motor drive (IMD) system having a plurality of integrated power modules, wherein each of the integrated power modules includes one or more battery cells and a power electronics assembly physically and electrically coupled to the one or more battery cells, the method comprising:
generating, by the power electronics assembly of an integrated power module of the plurality of integrated power modules, AC power on a set of load terminals using DC power from the one or more battery cells connected to a DC port of the integrated power module;
determining a total DC current (*I_{dc}*) on the DC port of the integrated power module;
measuring a battery voltage (*V_{batt}*) of the one or more battery cells of the integrated power module;
determining, based on the battery voltage (*V_{batt}*), a capacitor current (*I_{cap}*) through a DC link capacitor connected in parallel with the one or more battery cells of the integrated power module; and
determining, based on the total DC current (*I_{dc}*) and the capacitor current (*I_{cap}*), the battery current (*I_{batt}*) in the one or more battery cells of the integrated power module.

2. The method of Claim 1, wherein the IMD system does not include any sensors for directly measuring the battery current (*I_{batt}*)*.*

3. The method of Claim 1 or 2, wherein determining the total DC current (*I_{dc}*) further includes:
determining a phase current (*Iₐ, I_{b}, I_{c})* of the AC power on the set of load terminals; and
determining the total DC current (*I_{dc}*) based on the phase current (*Iₐ, I_{b}, I_{c}*) and based on a switching condition of the power electronics assembly.

4. The method of any one of Claims 1 to 3, wherein determining the capacitor current (*I_{cap}*) further includes calculating the capacitor current (*I_{cap}*) by modeling the DC link capacitor as a series resistor-capacitor (RC) circuit.

5. The method of Claim 4, wherein determining the capacitor current (*I_{cap}*) further includes calculating the capacitor current (*I_{cap}*) in accordance with: ${I}_{cap} \left[k\right] = \frac{{V}_{cap} \left[k\right] ⋅ 2 {C}_{f} - {V}_{cap} \left[k-1\right] ⋅ 2 {C}_{f} - I \left[k-1\right] ⋅ \left({T}_{s}-2{C}_{f}{R}_{f}\right)}{2 {C}_{f} {R}_{f} + {T}_{s}}$ , where *C_{f}* is a capacitance of the resistor-capacitor (RC) series branch, and *R_{f}* is a resistance in series with the capacitor.

6. The method of any one of Claims 1 to 5, wherein generating the alternating current (AC) power on the set of load terminals further includes operating the power electronics assembly of the integrated power module using a unipolar pulse-width modulation (PWM) switching technique.

7. The method of any one of Claims 1 to 6, wherein generating the alternating current (AC) power on the set of load terminals further includes operating the power electronics assembly of the integrated power module using a pulse-width modulation (PWM) switching technique with deadtime.

8. The method of any one of Claims 1 to 7, further including determining, based on the total DC current (*I_{dc}*) and the battery current (*I_{batt}*), a battery resistance (*R_{batt}*) of the one or more battery cells of the integrated power module.

9. The method of Claim 8, wherein determining the battery resistance (*R_{batt}*) of the one or more battery cells of the integrated power module further includes calculating the battery resistance (*R_{batt}*) in accordance with: $\frac{\left|{I}_{batt}\left(jω\right)\right|}{\left|{I}_{dc}\left(jω\right)\right|} = \frac{\sqrt{a + 1}}{\sqrt{{bR}_{batt}^{2} + {cR}_{batt} + \left(1+d\right)}}$, where ω is an angular speed of a modulation of the total DC current (*I_{dc}*), *j* is $\sqrt{- 1}$, and a, b, c, and d are each constants.

10. The method of Claim 8 or 9, further including determining, based on the battery resistance (*R_{batt}*)*,* a state of health (SoH) of the one or more battery cells of the integrated power module.

11. The method of any one of Claims 1 to 10, wherein determining the battery current (*I_{batt}*) in the one or more battery cells of the integrated power module further includes determining the battery current (*I_{batt}*) in each integrated power module of the plurality of integrated power modules.

12. A method for determining an impedance spectrum of a battery in an integrated motor drive (IMD) system having a plurality of integrated power modules, wherein each of the integrated power modules includes one or more battery cells and a power electronics assembly physically and electrically coupled to the one or more battery cells and configured to generate an AC power on a set of load terminals using DC power from the one or more battery cells of the integrated power module and for driving a motor having a winding connected to the set of load terminals, the method comprising:
commanding a plurality of switches in the power electronics assembly of an integrated power module of the plurality of integrated power modules to draw a sinusoidal battery current (*I_{batt}*) from the one or more battery cells of the integrated power module and having a value with a small amplitude that is substantially smaller than an amplitude of the battery current (*I_{Batt}*) when operating integrated power module for driving the motor;
measuring a battery voltage (*V_{batt}*) of the one or more battery cells of the integrated power module;
adjusting the commanding of the plurality of switches in the power electronics assembly to adjust a frequency of the sinusoidal battery current (*I_{batt}*) to step between a plurality of different frequency values;
recording, at each of the plurality of different frequency values, waveforms of the sinusoidal battery current (*I_{batt}*) and the battery voltage (*V_{batt}*) of the one or more battery cells of the integrated power module; and
determining, based on the waveforms of the sinusoidal battery current (*I_{batt}*) and the battery voltage (*V_{batt}*), real and imaginary impedance values of the one or more battery cells of the integrated power module at each of the plurality of different frequency values, thereby providing the impedance spectrum of the one or more battery cells of the integrated power module.

13. The method of Claim 12, further including determining, based on the impedance spectrum, a state of health (SoH) of the one or more battery cells of the integrated power module; and/or
wherein determining the real and imaginary impedance values of the one or more battery cells of the integrated power module further includes calculating the real and imaginary impedance values at each of the plurality of different frequency values and using a fast Fourier transform (FFT).

14. The method of Claim 12, wherein determining the real and imaginary impedance values of the one or more battery cells of the integrated power module further includes determining the real and imaginary impedance values of the one or more battery cells in each integrated power module of the plurality of integrated power modules.

15. An integrated motor drive (IMD) system, comprising:
a plurality of integrated power modules, wherein each of the integrated power modules includes one or more battery cells and a power electronics assembly physically and electrically coupled to the one or more battery cells and configured to generate AC power on a set of load terminals using DC power from the one or more battery cells connected to a DC port of the integrated power module;
wherein the plurality of integrated power modules are arranged to supply the AC power to a motor via an output terminal;
a phase voltage sensor configured to measure a phase voltage of the output terminal; and
a controller, wherein the controller is configured to:
receive a signal from the phase voltage sensor representing the phase voltage of the output terminal;
determine a step change in the phase voltage of the output terminal;
determine, based on the step change in the phase voltage of the output terminal, a DC-side battery current of the one or more battery cells of at least one of the plurality of integrated power modules; and
adjust an operating characteristic of the power electronics assembly of the at least one of the plurality of integrated power modules based on the DC-side battery current of the one or more battery cells of at least one of the plurality of integrated power modules.
